# EUROPÄISCHE PATENTSCHRIFT

(11) **EP 3 008 761 B1**
(45) Veröffentlichungstag und Bekanntmachung des Hinweises auf die Patenterteilung: **06.09.2017**
(21) Anmeldenummer: 14729915.0
(22) Anmeldetag: 13.06.2014
(51) Int. Cl.: H01L 41/047, H01L 41/293, H01L 41/083

(54) **VIELSCHICHTBAUELEMENT MIT EINER AUSSENKONTAKTIERUNG**
MULTILAYERCOMPONENT WITH AN OUTER CONTACT
COMPOSANT MULTICOUCHE AVEC UN CONTACT EXTERNE

(30) Priorität: 14.06.2013 DE 102013106223
(43) Veröffentlichungstag der Anmeldung: 20.04.2016
(73) Patentinhaber: Epcos AG, 81669 München (DE)
(72) Erfinder: GALLER, Martin, A-8401 Kalsdorf (AT); KASTL, Harald, A-8524 Deutschlandsberg (AT); FELLNER, Siegfried, A-8413 St. Georgen (AT); PECINA, Axel, A-8543 St. Martin (AT); OTTLINGER, Marion, A-8530 Deutschlandsberg (AT); GERLETZ, Peter, A-8045 Graz (AT); KRUMPHALS, Robert, A-8530 Deutschlandsberg (AT); ATHENSTAEDT, Wolfgang, A-8010 Graz (AT); JAGUST, Ivan, 10000 Zagreb (HR); MIJOCEVIC, Zdravko, 44320 Kutina (HR); MARIC, Zeljko, 44000 Sisak (HR)
(74) Vertreter: Epping - Hermann - Fischer
(86) Internationale Anmeldenummer: PCT/EP2014/062448
(87) Internationale Veröffentlichungsnummer: WO 2014/198936

(56) Entgegenhaltungen:
- WO-A1-02/39510
- WO-A1-2005/124884
- WO-A2-03/005490
- DE-A1-102009 034 099
- JP-A- 2005 183 478

## Beschreibung

Es wird ein Vielschichtbauelement mit einer Außenkontaktierung, einer Weiterkontaktierung und einem Verbindungselement angegeben. Beispielsweise ist das Vielschichtbauelement ein Piezoaktor, der zum Betätigen eines Einspritzventils in einem Kraftfahrzeug eingesetzt werden kann. Alternativ kann das Vielschichtbauelement beispielsweise ein Vielschichtkondensator oder ein Vielschichtvaristor sein.

Dokument DE 199 30585 A1 beschreibt einen Piezoaktor, der zur elektrischen Kontaktierung einer Elektrode eine Kontaktfahne aufweist. Dokument DE 10 2009 054 068 A1 beschreibt Außenelektroden in Form von Drahtgeweben. WO 03/005490 A2 zeigt einen Piezoaktor, der über eine Weiterkontaktierung elektrisch kontaktiert ist, die eine Vorverformung aufweistm um schädliche mechanische Zug-/Druck-Wechselbelastungen zu minimieren. Weitere Möglichkeiten zur Kontaktierung eines Piezoaktors sind beispielsweise aus DE 102009034099 A1, WO 2005/124884 A1 und WO 02/39510 A1 bekannt.

Ferner offenbart JP 2005 183478 A ein Vielschichtbauelement, das mit einem wellenförmigen Element kontaktiert ist.

Zur Kontaktierung eines Vielschichtbauelements wird beispielsweise eine Außenkontaktierung des Vielschichtbauelements mit einer Weiterkontaktierung verlötet. Hierbei können jedoch mechanische Spannungen zwischen der Weiterkontaktierung und der Außenkontaktierung entstehen. Diese können zur Beschädigung oder zum Ausfall des Vielschichtbauelements führen.

Es ist eine zu lösende Aufgabe, ein verbessertes Vielschichtbauelement anzugeben. Insbesondere ist es eine zu lösende Aufgabe, ein besonders zuverlässiges Vielschichtbauelement anzugeben.

Es wird ein Vielschichtbauelement aufweisend einen Grundkörper mit einer darauf angeordneten Außenkontaktierung, einer Weiterkontaktierung zur elektrischen Kontaktierung des Vielschichtbauelement und einem Verbindungselement zur Verbindung der Außenkontaktierung und der Weiterkontaktierung gemäß dem unabhängigen Vorrichtungsanspruchs 1 angegeben. Das Verbindungselement ist derart ausgebildet, eine Entkopplung von in der Weiterkontaktierung auftretenden mechanischen Spannungen von der Außenkontaktierung bewirkt wird. Dies bedeutet insbesondere, dass in der Weiterkontaktierung auftretende mechanische Spannungen von der Außenkontaktierung entkoppelt sind und umgekehrt. Bevorzugt ist das Verbindungselement so ausgebildet, dass es lediglich den elektrischen Kontakt zwischen Außenkontaktierung und Weiterkontaktierung herstellt und keine nennenswerte mechanische Kopplung zwischen der Außenkontaktierung und der Weiterkontaktierung erzeugt.

Der Vorteil eines Vielschichtbauelements mit einer Entkopplung von mechanischen Spannungen zwischen der Weiterkontaktierung und der Außenkontaktierung ist, dass eine Entlastung der Außenkontaktierung am Grundkörper gegenüber Belastungen von der Weiterkontaktierung erzielt werden kann. Dadurch kann eine Beschädigung der Außenkontaktierung verhindert werden. Auch die Verbindung zwischen der Weiterkontaktierung und der Außenkontaktierung wird entlastet. Zum Beispiel kann verhindert werden, dass Zugbelastungen über die Weiterkontaktierung an der Außenkontaktierung angreifen können. Insbesondere wird verhindert, dass die unter einer mechanischen Belastung stehende Weiterkontaktierung diese an die Außenkontaktierung überträgt. Zudem können Relativbewegungen zwischen der Außenkontaktierung und der Weiterkontaktierung ausgeglichen werden.

Der Grundkörper des Vielschichtbauelements kann einen Stapel aus dielektrischen Schichten und internen Elektrodenschichten aufweisen. Die Außenkontaktierung kann zur elektrischen Kontaktierung der internen Elektrodenschichten dienen. Der Grundkörper ist beispielsweise quaderförmig ausgebildet.

Vorzugsweise sind die dielektrischen Schichten und die internen Elektrodenschichten entlang einer Stapelrichtung gestapelt. Die Stapelrichtung entspricht vorzugsweise der Längsrichtung des Grundkörpers. Vorzugsweise sind die dielektrischen Schichten und die internen Elektrodenschichten alternierend übereinander gestapelt.

Vorzugsweise enthalten die internen Elektrodenschichten Kupfer oder bestehen aus Kupfer. Alternativ enthalten die internen Elektrodenschichten Silber-Palladium oder bestehen aus Silber-Palladium. Alternativ enthalten die internen Elektrodenschichten ein anderes elektrisch leitfähiges Material.

Die dielektrischen Schichten können ein piezoelektrisches Material aufweisen. Beispielsweise können die dielektrischen Schichten ein keramisches Material, insbesondere ein piezokeramisches Material aufweisen. Zur Herstellung des Grundkörpers können Grünfolien verwendet werden, auf die zur Bildung von internen Elektrodenschichten beispielsweise eine Metallpaste aufgebracht wird. Beispielsweise wird die Metallpaste in einem Siebdruckverfahren aufgebracht. Die Metallpaste kann Kupfer enthalten. Alternativ kann die Metallpaste Silber oder Silber-Palladium enthalten. Nach dem Aufbringen der Metallpaste werden die Folien vorzugsweise gestapelt, verpresst und gemeinsam gesintert, sodass ein monolithischer Sinterkörper entsteht. Vorzugsweise wird der Grundkörper des Bauelements durch einen monolithischen Sinterkörper gebildet, beispielsweise durch einen wie oben beschrieben hergestellten Sinterkörper.

Beispielsweise ist das Vielschichtbauelement als piezoelektrisches Bauelement, zum Beispiel als Piezoaktor, ausgebildet. Bei einem Piezoaktor dehnen sich beim Anlegen einer Spannung an die internen Elektrodenschichten zwischen den internen Elektrodenschichten angeordnete piezoelektrische Schichten aus, sodass ein Hub des Piezoaktors erzeugt wird. Das Vielschichtbauelement kann auch als ein anderes Bauelement ausgebildet sein, beispielsweise als Vielschichtkondensator.

Beispielsweise wird die Elektrodenpaste so aufgebracht, dass die Elektrodenschichten in Stapelrichtung gesehen abwechselnd bis zu einer Außenseite des Stapels reichen und von der gegenüberliegenden Außenseite des Stapels beabstandet sind. Auf diese Weise können die Elektrodenschichten abwechselnd mit einer der Außenelektroden elektrisch verbunden werden.

Alternativ kann das Vielschichtbauelement ein vollaktives Vielschichtbauelement sein. Bei einem vollaktiven Vielschichtbauelement erstrecken sich die internen Elektrodenschichten über den gesamten Querschnitt des Grundkörpers. Zur abwechselnden Verbindung der internen Elektrodenschichten mit der Außenkontaktierung werden die internen Elektrodenschichten auf einer Außenseite alternierend mit elektrisch isolierendem Material bedeckt. Vorzugsweise sind die internen Elektrodenschichten in Stapelrichtung abwechselnd mit einer der Außenelektroden elektrisch verbunden und von der anderen Außenelektrode elektrisch isoliert.

Die Außenkontaktierung dient vorzugsweise zum Anlegen einer Spannung zwischen in Stapelrichtung benachbarten internen Elektrodenschichten. Insbesondere dient die Außenkontaktierung der Zuleitung von elektrischem Strom zu den internen Elektrodenschichten. Insbesondere dient die Außenkontatkierung dazu, elektrischen Strom im Vielschichtbauelement zu verteilen. Die Außenkontkaktierung ist vorzugsweise direkt auf dem Grundkörper angeordnet. Insbesondere ist die Außenkontaktierung vollflächig mit dem Grundkörper verbunden.

Die Außenkontaktierung weist beispielsweise zwei Außenelektroden auf. Die Außenelektroden sind vorzugsweise auf gegenüberliegenden Außenseiten des Grundkörpers angeordnet. Vorzugsweise sind die internen Elektrodenschichten in Stapelrichtung abwechselnd mit einer der Außenelektroden elektrisch verbunden und von der anderen Außenelektrode elektrisch isoliert. Die Außenkontaktierung kann dabei auf die Belastungen an dem Grundkörper ausgelegt sein.

Die Außenkontaktierung ist beispielsweise streifenförmig ausgebildet. Vorzugsweise verläuft die Außenkontaktierung entlang der Stapelrichtung des Grundkörpers. Beispielsweise bedeckt die Außenkontaktierung eine Außenseite des Grundkörpers nur teilweise. Alternativ kann die Außenkontaktierung eine Außenseite des Grundkörpers vollständig bedecken.

Die Außenkontaktierung kann beispielsweise als Blech, als Sieb oder mäanderförmig ausgebildet sein. In diesem Fall kann die Außenkontaktierung mit dem Grundkörper verlötet sein. Beispielsweise ist die Außenkontaktierung über eine Außenmetallisierung, eine Sputterschicht, Lot oder Leitkleber auf einer Seitenfläche des Grundkörpers mit diesem verbunden. Insbesondere ist die Außenkontaktierung mit den internen Elektrodenschichten direkt verbunden. Alternativ kann die Außenkontaktierung als Schicht mittles Siebdruckverfahren auf eine Seitenfläche des Grundkörpers aufgetragen werden.

Die Weiterkontaktierung kann beispielsweise als Pin oder als Blechstreifen ausgebildet sein. Die Weiterkontaktierung kann mit einer externen Stromquelle verbunden sein. Insbesondere dient die Weiterkontaktierung der Zuleitung von elektrischem Strom bzw. elektrischer Spannung zu der Außenkontaktierung.

Das Verbindungselement ist vorzugsweise ein Element mit einer geringen Steifigkeit. Vorzugsweise weist das Verbindungselement eine hohe Flexibilität auf. Dadurch wird eine Entkopplung von mechanischen Belastungen zwischen der Weiterkontaktierung und der Außenkontaktierung und damit dem Grundkörper erzielt.

Das Verbindungselement kann beispielsweise als mäanderförmiges Drahtelement, als Siebelement oder als Blech ausgebildet sein.

Durch die Verwendung eines Verbindungselements zwischen der Weiterkontaktierung und der Außenkontaktierung wird ein platzsparendes Außenkontaktierungsdesign ermöglicht. Insbesondere muss die Außenkontaktierung nicht um eine Ecke des Grundkörpers geführt werden.

Des Weiteren ist das Rastermaß der Anschlussstelle zur Weiterkontaktierung innerhalb großer Grenzen frei wählbar. Insbesondere können die Abstände zwischen den einzelnen Elementen, z. B. Pins, der Weiterkontaktierung variiert werden.

Außerdem kann die Weiterkontaktierung frei angeordnet werden. Dadurch kann Raum für die Platzierung von zusätzlichen Elementen an der Weiterkontaktierung geschaffen werden. Solche zusätzlichen Elemente können insbesondere innerhalb eines Vergusses angeordnet sein. Zum Beispiel kann eine Isolationsschicht an der Weiterkontaktierung vorhanden sein. Eine solche Isolationsschicht wirkt sich vorteilhaft hinsichtlich der Kriechstromfestigkeit aus.

Gemäß einer Ausführungsform ist das Verbindungselement als separates Element zur Außenkontaktierung ausgebildet.

Gemäß einer weiteren Ausführungsform ist das Verbindungselement als integrales Element der Außenkontaktierung ausgebildet. Insbesondere kann das Verbindungselement einen Fortsatz der Außenkontaktierung umfassen. Beispielsweise kann die Außenkontaktierung einen Fortsatz aufweisen, der nicht fest mit dem Grundkörper verbunden ist. Dieser Fortsatz kann derart umgebogen sein, dass er bei Draufsicht auf die Seitenfläche des Grundkörpers oberhalb der Außenkontaktierung verläuft. Der Fortsatz verläuft vorzugsweise parallel oder annähernd parallel zur Außenkontaktierung. Gemäß einer Ausführungsform verläuft der Fortsatz in einem spitzen Winkel zur Außenkontaktierung. Der Fortsatz kann entlang einer Kante umgebogen sein, welche senkrecht zur Stapelrichtung des Grundkörpers verläuft.

Gemäß einer Ausführungsform sind die Außenkontaktierung, das Verbindungselement und die Weiterkontaktierung jeweils als separate Elemente zueinander ausgebildet. Gemäß einer weiteren Ausführungsform können die Außenkontaktierung, das Verbindungselement und die Weiterkontaktierung einteilig ausgebildet sein.

Gemäß einer Ausführungsform verläuft das Verbindungselement in einer Ebene entlang einer Seitenfläche des Grundkörpers. Die Ebene verläuft beispielsweise parallel oder annähernd parallel zum Grundkörper. In einer weiteren Ausführungsform kann die Ebene in einem spitzen Winkel zur Seitenfläche verlaufen. Insbesondere ist das Verbindungselement eben ausgebildet. D. h., dass das Verbindungselement frei von Krümmungen ist. Kleine Krümmungen welche lokal im Bereich der Befestigung des Verbindungselements an der Außenkontaktierung oder der Weiterkontaktierung auftreten können hierbei vernachlässigt werden.

Die Kanten des Verbindungselements welche parallel zur Stapelrichtung verlaufen sind vorzugsweise freistehend, d. h. sie sind nicht fest mit dem Grundkörper verbunden. Dadurch ist das Verbindungselement in einer Richtung senkrecht zur Stapelrichtung beweglich. Dies wirkt sich vorteilhaft auf die Entkopplung mechanischer Spannungen zwischen der Weiterkontaktierung und der Außenkontaktierung aus.

Die Befestigung des Verbindungselements an der Außenkontaktierung erfolgt vorzugsweise entlang einer Kante des Verbindungselements, welche senkrecht zur Stapelrichtung des Grundkörpers verläuft. Alternativ kann das Verbindungselement nur über einen einzelnen Kontaktpunkt mit der Außenkontaktierung verbunden sein. Beispielsweise kann das Verbindungselement mit der Außenkontaktierung verlötet sein. Alternativ kann das Verbindungselement mittels eines Leitklebers mit der Außenkontaktierung verbunden sein. Alternativ kann das Verbindungselement mit der Außenkontaktierung verschweißt sein. Die Verbindung des Verbindungselements mit der Weiterkontaktierung kann ebenfalls mittels Lötens, Schweißens oder mittels Leitklebers erfolgen.

Gemäß einer Ausführungsform ist das Verbindungselement zwischen der Außenkontaktierung und der Weiterkontaktierung, durchgehend von dem Grundkörper beabstandet. D. h, dass das Verbindungselement zwischen seinen Enden, welche mit der Außenkontaktierung und der Weiterkontaktierung verbunden sind, keine weiteren Berührungspunkte mit der Außenkontaktierung hat.

Gemäß einer Ausführungsform ist die Weiterkontaktierung derart angeordnet, dass sie mit dem Grundkörper in longitudinaler Richtung überlappt. Die Überlappung wirkt sich vorteilhaft auf die Kriechstromfestigkeit aus. Beispielsweise überlappt die Weiterkontaktierung mit ca. einem Drittel des Grundkörpers. Die Weiterkontaktierung kann jedoch auch mit mehr oder weniger als einen Drittel des Grundkörpers überlappen.

Die Weiterkontaktierung kann vom Grundkörper beabstandet angeordnet sein.

Im Folgenden wird das Vielschichtbauelement anhand von schematischen und nicht maßstabsgetreuen Figuren erläutert.

Es zeigen:
- Figur 1: ein Vielschichtbauelement mit einer Außenkontaktierung, einer Weiterkontaktierung und einem Verbindungselement in einer Seitenansicht,
- Figur 2: ein Vielschichtbauelement mit zwei unterschiedlichen Ausführungsformen des Verbindungselements in einer Seitenansicht,
- Figur 3: ein Vielschichtbauelement mit einer weiteren Ausführungsform des Verbindungselements und der Weiterkontaktierung in einer Seitenansicht,
- Figur 4: ein Vielschichtbauelement mit einer weiteren Ausführungsform des Verbindungselements und der Weiterkontaktierung in einer Seitenansicht.

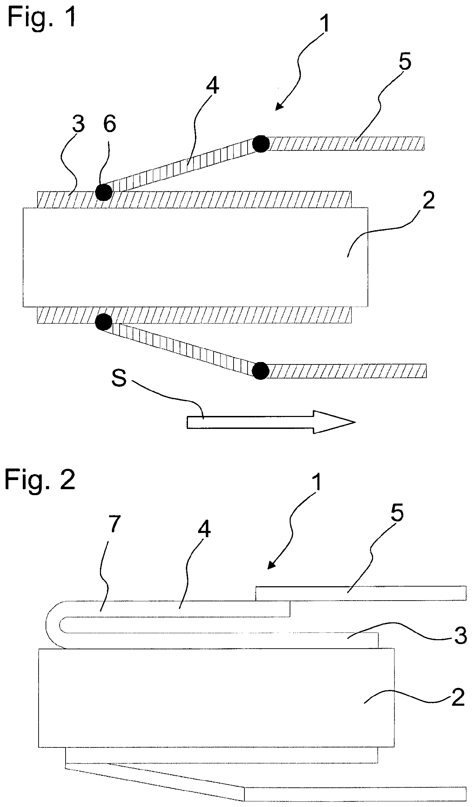

Figur 1 zeigt ein Vielschichtbauelement 1. Das Vielschichtbauelement 1 weist einen Grundkörper 2 mit einem Stapel aus alternierend angeordneten internen Elektrodenschichten und piezoelektrischen Schichten auf (nicht gezeigt). Auf zwei gegenüberliegenden Seiten des Grundkörpers ist eine Außenkontaktierung 3 angeordnet. Die Außenkontaktierung 3 kann beispielsweise ein Siebgewebe, ein mäanderförmiges Element oder ein Blech aufweisen. Die Außenkontaktierung 3 ist zur Kontaktierung der internen Elektrodenschichten ausgebildet.

An der Außenkontaktierung 3 sind zwei Verbindungselemente 4 angeordnet. Die Verbindungselemente 4 können ein Siebgewebe, ein flexibles Blech oder ein mäanderförmiges Element aufweisen. Die Verbindungselemente 4 verbinden die Außenkontaktierung 3 mit einer Weiterkontaktierung 5. Die Verbindungselemente 4 sind an ihren äußeren Kanten, bzw. ihren Extrempunkten, jeweils mit der Außenkontaktierung 3 und mit der Weiterkontaktierung 5 verbunden. Die Verbindung des Verbindungselements 4 mit der Außenkontaktierung 3 kann in einem einzelnen Punkt, z. B. einem Lötpunkt, oder in einer einzelnen Verbindungslinie, welche senkrecht zur Stapelrichtung S verläuft, bestehen. Ein solcher Lötpunkt, bzw. eine solche Verbindungslinie sind in Figur 1 durch den Punkt 6 angedeutet. Abgesehen davon ist das Verbindungselement 4 von der Seitenfläche des Grundkörpers 2, bzw. von der Außenkontaktierung 3 beabstandet angeordnet. Das Verbindungselement 4 schließt dabei mit der Seitenfläche des Grundkörpers einen spitzen Winkel ein.

Die Weiterkontaktierungen 5 sind von dem Grundkörper 2 beabstandet angeordnet. Zudem sind die Weiterkontaktierungen 5 senkrecht zur Stapelrichtung S angeordnet. In einer weiteren Ausführungsform können die Weiterkontaktierungen 5 auch zur Stapelrichtung S geneigt sein.

Die Weiterkontaktierungen 5 sind in longitudinaler Richtung mit dem Grundkörper 2 überlappend angeordnet. Dies wirkt sich vorteilhaft auf die Kriechstromfestigkeit aus. Insbesondere überlappen die Weiterkontaktierungen 5 mit ca. einem Drittel des Grundkörpers 2.

Die Verbindungselemente 4 weisen eine hohe Flexibilität auf. Auf diese Weise kann eine Entkopplung mechanischer Spannungen zwischen den Weiterkontaktierungen 5 und der Außenkontaktierung 3 stattfinden. Dadurch kann eine Entlastung der Außenkontaktierung 3 gegenüber Belastungen von der Weiterkontaktierung 5 stattfinden. Insbesondere werden eventuell auftretende Vibrationen nicht von den Weiterkontaktierungen 5 auf die Außenkontaktierung 3 oder auf den Grundkörper 2 übertragen und umgekehrt. Dadurch kann eine Beschädigung des Vielschichtbauelements 1 vermieden werden.

Figur 2 zeigt ein Vielschichtbauelement 1 mit zwei weiteren Ausführungsformen eines Verbindungselements 4. Üblicherweise werden jedoch zwei gleichartige Verbindungselemente 4 an einem Vielschichtbauelement 2 angeordnet.

Die in Figur 2 unten angeordnete Ausführungsform ist ähnlich wie die in Figur 1 gezeigte Ausführungsform, abgesehen davon, dass das Verbindungselement 4 am Ende der Außenkontaktierung 3 mit diesem verbunden ist, insbesondere an einem von der Weiterkontaktierung 5 abgewandten Ende der Außenkontaktierung 3. In Figur 1 hingegen ist das Verbindungselement 4 in einem mittleren Bereich der Außenkontaktierung 3 mit dieser verbunden.

Bei der in Figur 2 oben angeordneten Ausführungsform ist das Verbindungselement 4 als integraler Bestandteil der Außenkontaktierung 3 ausgebildet. Insbesondere weist die Außenkontaktierung 3 einen Fortsatz 7 auf, welcher als Verbindungselement 4 dient. Der Fortsatz 7 ist nicht direkt mit dem Grundkörper 2 verbunden. Dadurch ist es möglich, den Fortsatz 7 wie in Figur 2 dargestellt umzubiegen, so dass er parallel zur Außenkontaktierung 2, bzw. zur Seitenfläche des Grundkörpers 2 verläuft.

Die Weiterkontaktierung 5 ist mit dem freien Ende des Fortsatzes 7 verbunden. Das freie Ende bezeichnet das Ende des Fortsatzes 7, welches nicht direkt mit dem Grundkörper verbunden ist.

Die Ausführungsform, bei der das Verbindungselement 4 als integraler Bestandteil der Außenkontaktierung 3, insbesondere als Fortsatz 7 der Außenkontaktierung 3 ausgebildet ist, bietet den Vorteil, dass das Verbindungselement 4 nicht an der Außenkontaktierung befestigt werden muss. Dadurch kann das Herstellungsverfahren des Vielschichtbauelements 1 vereinfacht werden.

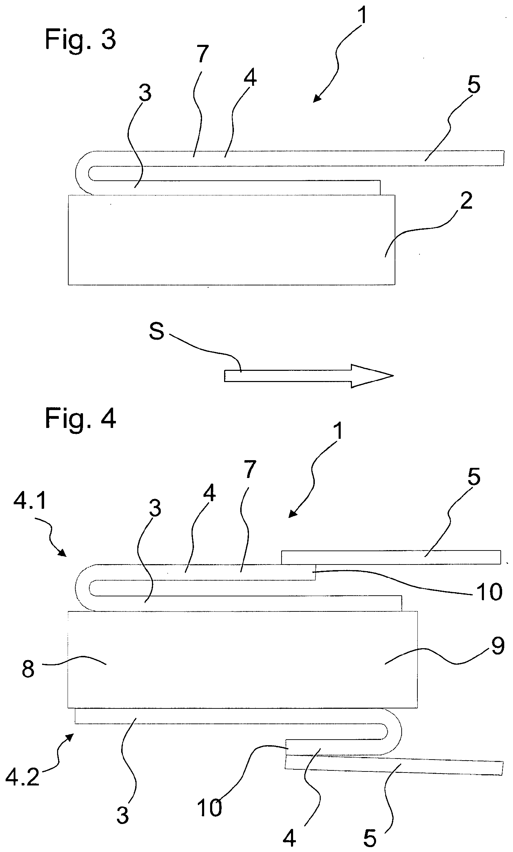

Figur 3 zeigt eine weitere Ausführungsform eines Vielschichtbauelements 1. Figur 3 zeigt eine Außenkontaktierung 3 mit einem Fortsatz 7, der ähnlich wie in Figur 2 gezeigt parallel zur Außenkontaktierung 3 verläuft. Im Unterschied zu der in Figur 2 gezeigten Ausführungsform erstreckt sich der Fortsatz 7 über den Grundkörper 2 hinaus. Auf diese Weise dient der Fortsatz 7 der Außenkontaktierung gleichzeitig als Verbindungselement 4 und als Weiterkontaktierung 5. Dadurch kann das Herstellverfahren des Vielschichtbauelements 1 weiter vereinfacht werden. Zudem weist in dieser Ausführungsform auch die Weiterkontaktierung 5 eine hohe Flexibilität auf. Dadurch ist die Entkopplung von mechanischen Spannungen zwischen den Weiterkontaktierungen 5 und der Außenkontaktierungen 3 zusätzlich verbessert.

Figur 4 zeigt zwei unterschiedliche Möglichkeiten, die Weiterkontaktierungen 5 an einem Fortsatz 7 der Außenkontaktierung 3 anzubringen, welcher wie vorhergehend beschrieben als Verbindungselement 4 dienen kann.

Die in Figur 4 oben gezeigte Lösung wurde bereits in Figur 2 beschrieben. Sie soll hier nochmals zum besseren Vergleich dargestellt werden. Im Folgenden wird die oben gezeigte Ausführungsform als Ausführungsform 4.1 bezeichnet. In der Ausführungsform 4.1 ist das Verbindungselement 4 am freien Ende 8 des Vielschichtbauelements 1 befestigt. Das Verbindungselement 4 erstreckt sich dabei annähernd über die Länge der Außenkontaktierung 3 in Stapelrichtung S. Das freie Ende 8 des Vielschichtbauelements 1 ist das Ende, welches beim Anlegen einer Spannung zwischen den internen Elektrodenschichten auslenkbar ist. Das fixierte Ende 9 des Vielschichtbauelements 1 ist das Ende, an welchem der Grundkörper 2 fest gelagert ist. Insbesondere sitzt am fixierten Ende 9 ein Anschlag des Vielschichtbauelements 1. Das fixierte Ende 9 ist das Ende des Vielschichtbauelements 1, welches zu der Weiterkontaktierung 5 hin gerichtet ist.

In der unten gezeigten Ausführungsform, im Folgenden als Ausführungsform 4.2 bezeichnet, ist das Verbindungselement 4 am fixierten Ende 9 des Vielschichtbauelements 1 befestigt. In dieser Ausführungsform erstreckt sich das Verbindungselement 4 nur über einen Teilbereich der Außenkontaktierung 3. Insbesondere erstreckt sich das Verbindungselement über ca. 1/3 der Außenkontaktierung 3. In einer weiteren Ausführungsform kann sich das Verbindungselement 4 auch über die Hälfte oder über ¾ der Außenkontaktierung erstrecken.

Die Ausführungsform 4.2 mit dem kürzeren Verbindungselement 4 ist vorteilhaft hinsichtlich des Materialeinsatzes. Insbesondere sind aufgrund der geringeren Länge des Verbindungselementes 4 die Materialkosten geringer als bei der in Figur 4 oben gezeigten Ausführungsform.

Die Ausführungsform 4.1, bei der sich das Verbindungselement 4 über die gesamte Länge der Außenkontaktierung 3 erstreckt, ist vorteilhaft hinsichtlich der Flexibilität des Verbindungselements. Insbesondere ist die Weiterkontaktierung 5 bei der oben gezeigten Ausführungsform außerhalb des Bereichs des Biegeradius des Fortsatzes 7, bzw. des Verbindungselements 4 angeordnet. Dadurch kann das freie Ende 8 des Verbindungselements 4 nahe an den Grundkörper 2 herangeführt werden. Somit kann auch die Weiterkontaktierung 5 nahe am Grundkörper 2 angeordnet sein. Insbesondere kann der Abstand zwischen einem freistehenden Ende 10 des Verbindungselements 4 und dem Grundkörper 2 kleiner sein als der Biegedurchmesser. Dadurch kann eine besonders platzsparende Anordnung erreicht werden.

Ein Weiterer Unterschied besteht darin, dass bei der Ausführungsform 4.1 das freistehende Ende 10 des Verbindungselements 4 zur Weiterkontaktierung 5 hin gerichtet ist, während bei der unten gezeigten Ausführungsform 4.2 das freisthende Ende 10 des Verbindungselements 4 von der Weiterkontaktierung 5 weg gerichtet ist.

Dadurch ergibt sich, dass bei der Ausführungsform 4.1 das Verbindungselement 4 und die Weiterkontaktierung 5 nur in einem kleinen Bereich relativ zur Gesamtlänge des Verbindungselements 4 überlappen. Dadurch bleibt ein Großteil des Verbindungselements 4 von der Weiterkontaktierung 5 unbeeinflusst.

Bei der Ausführungsform 4.2 hingegen überlappen sich die Weiterkontaktierung 5 und das Verbindungselement 4 nahezu vollständig.

### Bezugszeichenliste

- 1: Vielschichtbauelement
- 2: Grundkörper
- 3: Außenkontaktierung
- 4: Verbindungselement
- 5: Weiterkontaktierung
- 6: Punkt
- 7: Fortsatz
- 8: freies Ende des Vielschichtbauelements
- 9: fixiertes Ende des Vielschichtbauelements
- 10: freistehendes Ende des Verbindungselements

## Patentansprüche

1. Vielschichtbauelement (1), aufweisend einen Grundkörper (2) mit einer darauf angeordneten Außenkontaktierung (3), einer Weiterkontaktierung (5) zur elektrischen Kontaktierung des Vielschichtbauelements (1) und ein Verbindungselement (4) zur Verbindung der Außenkontaktierung (3) und der Weiterkontaktierung (5), wobei das Verbindungselement (4) derart ausgebildet ist, dass eine Entkopplung von in der Weiterkontaktierung (5) auftretenden mechanischen Spannungen von der Außenkontaktierung (3) bewirkt wird, wobei das Verbindungselement (4) als mäanderförmiges Drahtelement ausgebildet ist, und sich **dadurch kennzeichnet, dass** die Außenkontaktierung (3) mäanderförmig ausgebildet und dass, das Verbindungselement (4) ein integraler Bestandteil der Außenkontaktierung (3) ist.

2. Vielschichtbauelement nach Anspruch 1, wobei das Verbindungselement (4) eine geringe Steifigkeit aufweist.

3. Vielschichtbauelement nach einem der vorhergehenden Ansprüche, wobei das Verbindungselement in einer Ebene entlang einer Seitenfläche des Grundkörpers verläuft.

4. Vielschichtbauelement (1) nach einem der vorhergehenden Ansprüche, wobei das Verbindungselement (4) in einem Bereich zwischen der Außenkontaktierung (3) und der Weiterkontaktierung (5) durchgehend von der Seitenfläche des Grundkörpers (2) beabstandet ist.

5. Vielschichtbauelement (1) nach einem der vorhergehenden Ansprüche, wobei das Verbindungselement (4) einstückig ausgebildet ist.

6. Vielschichtbauelement (1) nach einem der vorhergehenden Ansprüche, wobei das Verbindungselement (4) einen Fortsatz (7) der Außenkontaktierung (3) umfasst.

7. Vielschichtbauelement (1) nach dem vorhergehenden Anspruch, wobei der Fortsatz (7) derart umgebogen ist, dass er annähernd parallel oder in einem spitzen Winkel zum Grundkörper (2) verläuft.

8. Vielschichtbauelement (1) nach einem der vorhergehenden Ansprüche, wobei das Verbindungselement (4) entlang einer Kante an der Außenkontaktierung (3) befestigt ist, welche senkrecht zur Stapelrichtung (S) verläuft.

9. Vielschichtbauelement nach einem der Ansprüche 1 bis 7, wobei das Verbindungselement über einen einzelnen Kontaktpunkt mit der Außenkontaktierung (3) verbunden ist.

10. Vielschichtbauelement (1) nach einem der vorhergehenden Ansprüche, wobei die Weiterkontaktierung (5) in longitudinaler Richtung mit dem Grundkörper (2) überlappt.

11. Vielschichtbauelement nach einem der vorhergehenden Ansprüche, wobei die Weiterkontaktierung (5) mit einer Isolationsschicht ummantelt ist.

## Claims

1. Multi-layer component (1), comprising a main body (2) with an external contact (3) arranged thereon, a further contact (5) for electrically contacting the multi-layer component (1), and a connecting element (4) for connecting the external contact (3) and the further contact (5), wherein the connecting element (4) is embodied in such a way that a decoupling of mechanical stresses that occur in the further contact (5) from the external contact (3) is brought about, wherein the connecting element (4) is embodied as a meandering wire element, and is **characterized in that** the external contact (3) is embodied in a meandering fashion and **in that** the connecting element (4) is an integral part of the external contact (3).

2. Multi-layer component according to Claim 1, wherein the connecting element (4) has a low stiffness.

3. Multi-layer component according to any of the preceding claims, wherein the connecting element runs in a plane along a side surface of the main body.

4. Multi-layer component (1) according to any of the preceding claims, wherein the connecting element (4) is spaced apart from the side surface of the main body (2) continuously in a region between the external contact (3) and the further contact (5).

5. Multi-layer component (1) according to any of the preceding claims, wherein the connecting element (4) is embodied integrally.

6. Multi-layer component (1) according to any of the preceding claims, wherein the connecting element (4) comprises an extension (7) of the external contact (3).

7. Multi-layer component (1) according to the preceding claim, wherein the extension (7) is bent over in such a way that it runs approximately parallel or at an acute angle with respect to the main body (2).

8. Multi-layer component (1) according to any of the preceding claims, wherein the connecting element (4) is fixed to the external contact (3) along an edge running perpendicular to the stacking direction (S).

9. Multi-layer component according to any of Claims 1 to 7, wherein the connecting element is connected to the external contact (3) via an individual contact point.

10. Multi-layer component (1) according to any of the preceding claims, wherein the further contact (5) overlaps the main body (2) in a longitudinal direction.

11. Multi-layer component according to any of the preceding claims, wherein the further contact (5) is enveloped with an insulation layer.

## Revendications

1. Composant multicouche (1), possédant un corps de base (2) sur lequel est disposé un élément de mise en contact extérieur (3), un élément de continuité de la mise en contact (5) destiné à la mise en contact électrique du composant multicouche (1) et un élément de liaison (4) destiné à relier l'élément de mise en contact extérieur (3) et l'élément de continuité de la mise en contact (5), l'élément de liaison (4) étant configuré de telle sorte que les tensions mécaniques qui se produisent dans l'élément de continuité de la mise en contact (5) sont découplées de l'élément de mise en contact extérieur (3), l'élément de liaison (4) étant réalisé sous la forme d'un élément en fil métallique en forme de méandres, **caractérisé en ce que** l'élément de mise en contact extérieur (3) est réalisé en forme de méandres et **en ce que** l'élément de liaison (4) fait partie intégrante de l'élément de mise en contact extérieur (3).

2. Composant multicouche selon la revendication 1, l'élément de liaison (4) possédant une faible rigidité.

3. Composant multicouche selon l'une des revendications précédentes, l'élément de liaison s'étendant dans un plan le long d'une paroi latérale du corps de base.

4. Composant multicouche (1) selon l'une des revendications précédentes, l'élément de liaison (4) étant constamment espacé de la paroi latérale du corps de base (2) dans une zone entre l'élément de mise en contact extérieur (3) et l'élément de continuité de la mise en contact (5).

5. Composant multicouche (1) selon l'une des revendications précédentes, l'élément de liaison (4) étant réalisé d'une seule pièce.

6. Composant multicouche (1) selon l'une des revendications précédentes, l'élément de liaison (4) comprenant un prolongement (7) de l'élément de mise en contact extérieur (3).

7. Composant multicouche (1) selon la revendication précédente, le prolongement (7) étant recourbé de telle sorte qu'il s'étend approximativement en parallèle ou selon un angle aigu par rapport au corps de base (2).

8. Composant multicouche (1) selon l'une des revendications précédentes, l'élément de liaison (4) étant fixé sur l'élément de mise en contact extérieur (3) le long d'une arête qui s'étend perpendiculairement à la direction de l'empilement (S).

9. Composant multicouche (1) selon l'une des revendications 1 à 7, l'élément de liaison étant relié à l'élément de mise en contact extérieur (3) par un point de contact unique.

10. Composant multicouche (1) selon l'une des revendications précédentes, l'élément de continuité de la mise en contact (5) chevauchant le corps de base (2) dans la direction longitudinale.

11. Composant multicouche (1) selon l'une des revendications précédentes, l'élément de continuité de la mise en contact (5) étant enrobé par une couche isolante.
